Europäisches Patentamt

European Patent Office

Office européen des brevets

(11) Publication number: **0 154 675 B1**

## EUROPEAN PATENT SPECIFICATION

(45) Date of publication of patent specification: **16.12.92**  (51) Int. Cl.5: **H01L 21/312**, H01L 21/306

(21) Application number: **84110267.6**

(22) Date of filing: **29.08.84**

(54) **A process for reactive ion etching a polymer film.**

(30) Priority: **12.10.83 US 541221**

(43) Date of publication of application:
**18.09.85 Bulletin 85/38**

(45) Publication of the grant of the patent:
**16.12.92 Bulletin 92/51**

(84) Designated Contracting States:
**DE FR GB**

(56) References cited:
**EP-A- 0 044 553**

**EXTENDED ABSTRACTS, vol. 80-2, 1980,
pages 848-850, abstract no. 328; W. LARSON
et al.: "Plasma etch processing for electron
resists"**

**JOURNAL OF THE ELECTROCHEMICAL SOCI-
ETY, vol. 130, no. 1, January 1983, pages
143-146; H. GOKAN et al.: "Dry etch resis-
tance of organic materials"**

**IBM TECHNICAL DISCLOSURE BULLETIN, vol.
25, no. 9, February 1983, page 4587, New
York, US; L.M. EPHRATH: "Teflon polymer
mask for rie of contact holes"**

**THIN SOLID FILMS, vol. 105, no. 4, July 1983,
pages 331-342, Elsevier Sequoia, NL; S.A.
JENEKHE et al.: "Diffusion and pemeation of
vapors in composite polymer thin films"**

(73) Proprietor: **International Business Machines
Corporation
Old Orchard Road
Armonk, N.Y. 10504(US)**

(72) Inventor: **Hiraoka, Hiroyuki
18635 Montewood Drive
Saratoga California 95070(US)**

(74) Representative: **Blakemore, Frederick Norman
IBM United Kingdom Limited Intellectual
Property Department Hursley Park
Winchester Hampshire SO21 2JN(GB)**

Rank Xerox (UK) Business Services

## Description

This invention relates to reactive ion etching of polymer films.

US-A-4,382,985 discloses the use of films of fluoroalkyl acrylate polymer as a resist.

EP-0044553 discloses a method of producing relief structures for integrated semiconductor circuits. A double layer of polymer is formed on a substrate. The method comprises at least one wet chemical step, namely development of an image in the upper layer, followed by either a dry or wet etch of the lower layer. In one embodiment (figure 3) both layers are etched away using the same wet developer.

The present invention seeks to provide a process for preparing a polymer pattern having a high resolution and a high aspect ratio.

A process for achieving this object is defined in claim 1.

When silanes or siloxanes are used as oxygen etch barriers, oxides like $SiO_2$ tend to deposit on the wafers during oxygen plasma or oxygen reactive ion etching. These oxides deposits are hard to remove. Aqueous solutions are sometimes used for such removal, but this is not a good solution. The present method avoids this problem by using halocarbon polymer etch barriers which do not deposit oxides in oxygen plasma, yet serve well as oxygen etch barriers. They also have the additional advantages that they can be removed completely in dry processing.

Hexafluorobenzene is the most preferred halocarbon to form a polymer etch barrier for use in the present method, but it may be replaced with other halocarbons such as pentafluorostyrene, perfluoro-1,3-butadiene or chlorocarbon compounds. The polymeric halocarbon films have the advantage that they are not readily oxidized. Thus, they work as excellent oxygen etch barriers, without depositing the hard-to-remove oxides encountered in the prior art.

The polymer film upon the substrate is, for example, PMMA, poly (methylmethacrylate), but any organic polymer film such as a novolac resin, a polystyrene, or a polyimide can be used.

This polymer film may be deposited by any of the many methods known to the art, for example by spin-coating, vapour deposition or plasma deposition. The usual substrate is silicon in the form of a wafer, but other materials also may be used.

The dry development is of great advantage in that it avoids the problems associated with solvents and liquid developers. Cracking, adhesion failures and swelling are also avoided. The process has been used to obtain high resolution and high aspect ratio polymer patterns with 0.5$\mu$m width and 4$\mu$m height, using dry development and no elaborate instruments.

## Examples

Hexafluorobenzene was deposited on PMMA (ca 4 $\mu$m thick) films in a hydrogen ion beam assisted polymer film deposition reaction, using a "see-through-mask", a mask prepared for electron beam proximity printing technology. The hydrogen pressure was 0.00266 Pascals (2 x $10^{-5}$ torr),and the hexafluorobenzene pressure was 0.00532 Pascals (4 x $10^{-5}$ torr).The ion gun used was a Commonwealth Sci. Co. Magmiller gun. Its dose level was in the order of 1 x $10^{-4}$ $C/cm^2$.

After depositing hexafluorobenzene etch barriers, the polymer images were developed in oxygen RIE; ca 200 bolt self-supporting bias potential, 100 micrometer oxygen pressure.

Measurements of the oxygen RIE rate of the etch barriers deposited from perfluorobenzene (and from pentafluorostyrene vapours) in proton beam induced polymerizations indicate the etch barriers were almost like graphite:

The etch rate in $O_2$ RIE: 4 to 5 nm/min.

(-200 volt bias, 0.22 $W/cm^2$ total power density)

This value may be compared with graphite etch rate of about 5 nm/min.

(-500 volt bias, argon)

The etch barriers were deposited on a silicon wafer, and their thickness change was measured with a Talystep.

The same RIE condition provides a PMMA etch rate of 150 nm/min.

## Claims

1. A process for preparing a high resolution and high aspect ratio polymer pattern, comprising
   a) depositing a polymer film on a substrate,
   b) depositing a halo-carbon polymer etch barrier on said polymer film,
   c) etching the exposed portions of said polymer film with reactive ions to yield development of said pattern in the dry state,

   characterized in that

   step b) is carried out in an atmosphere of halo-carbon and hydrogen by means of a hydrogen ion beam assisted polymer film deposition reaction using a see-through-mask.

2. A process as claimed in claim 1, wherein the halocarbon polymer is poly(perfluorobenzene).

3. A process as claimed in claim 1, wherein the halocarbon polymer is poly(perfluoro-1,3-butadiene).

4. A process as claimed in claim 1, wherein the halocarbon polymer is poly-(pentafluorostyrene).

5. A process as claimed in any preceding claim, wherein the etching process is an oxygen reactive ion etching process.

**Patentansprüche**

1. Verfahren zum Vorbereiten eines Polymermusters mit hoher Auflösung und hohem Seitenverhältnis, das aufweist:
   a) Aufbringen eines Polymerfilms auf einem Substrat,
   b) Aufbringen einer Ätzsperre aus einem Halogenkohlenstoffpolymer auf dem Polymerfilm,
   c) reaktives Ionenätzen der exponierten Teilstücke des Polymerfilms, um die Ausbildung des Musters in trockenem Zustand zu erzielen,

   **dadurch gekennzeichnet, daß**

   Schritt b) unter Verwendung einer Durchsichtsmaske mittels einer durch einen Wasserstoffionenstrahl unterstützten Polymerfilm-Abscheidungsreaktion in einer Halogenkohlenstoff- und Wasserstoffatmosphäre durchgeführt wird.

2. Verfahren nach Anspruch 1, bei welchem das Halogenkohlenstoffpolymer Poly-(Perfluorbenzol) ist.

3. Verfahren nach Anspruch 1, bei welchem das Halogenkohlenstoffpolymer Poly-(Perfluor-1,3-Butadien) ist.

4. Verfahren nach Anspruch 1, bei welchem das Halogenkohlenstoffpolymer Poly-(Pentafluorstyrol) ist.

5. Verfahren nach einem der vorigen Ansprüche, bei welchem der Ätzvorgang ein reaktiver Sauerstoffionenätzprozeß ist.

**Revendications**

1. Procédé pour préparer un motif de polymère de haute résolution et de rapport d'aspect élevé, comprenant:
   a) le dépôt d'un film de polymère sur un substrat,
   b) le dépôt d'une barrière d'attaque de polymère halocarboné sur ce film de polymère,
   c) l'attaque des parties exposées de ce film de polymère avec des ions réactifs pour fournir le développement de ce motif à l'état sec,
   caractérisé en ce que l'étape b) est effectuée dans une atmosphère d'halocarbure et d'hydrogène au moyen d'une réaction de dépôt de film de polymère assistée par un faisceau d'ions hydrogène avec un masque permettant la vision.

2. Procédé suivant la revendication 1, dans lequel le polymère halocarboné est un poly-(perfluorobenzène).

3. Procédé suivant la revendication 1, dans lequel le polymère halocarboné est un poly(perfluoro-1,3-butadiène).

4. Procédé suivant la revendication 1, dans lequel le polymère halocarboné est un poly-(pentafluorostyrène).

5. Procède suivant l'une quelconque des revendications, précédentes dans lequel le procédé d'attaque est un procédé d'attaque par ions réactifs d'oxygène.